**Europäisches Patentamt**

**European Patent Office**

**Office européen des brevets**

(11) Numéro de publication: **0 258 361 B1**

## FASCICULE DE BREVET EUROPEEN

(45) Date de publication de fascicule du brevet: **06.05.92**   (51) Int. Cl.⁵: **H01L 35/16**

(21) Numéro de dépôt: **87901499.1**

(22) Date de dépôt: **17.02.87**

(86) Numéro de dépôt internationale :
**PCT/FR87/00041**

(87) Numéro de publication internationale :
**WO 87/05154 (27.08.87 87/19)**

(54) **MATERIAUX SEMICONDUCTEURS THERMOELECTRIOUES ET PROCEDE DE PREPARATION.**

(30) Priorité: **19.02.86 FR 8602226**

(43) Date de publication de la demande:
**09.03.88 Bulletin 88/10**

(45) Mention de la délivrance du brevet:
**06.05.92 Bulletin 92/19**

(84) Etats contractants désignés:
**AT BE CH DE FR GB IT LI LU NL SE**

(56) Documents cités:
**AU-B-28 697 71**
**FR-A- 1 388 482**
**FR-A- 2 566 585**
**GB-A- 578 187**

(73) Titulaire: **CENTRE NATIONAL DE LA RECHER-CHE SCIENTIFIOUE (CNRS)**
**13 Ouai Anatole France**
**F-75700 Paris(FR)**

(72) Inventeur: **BRUN, Gérard 370, rue du Mail**
**St Clément la Rivière**

**F-34980 Saint-Gely du Fesc(FR)**
Inventeur: **MARIN-AYRAL, Rose-Marie**
**60, rue de l'Aigoual**
**F-34100 Montpellier(FR)**
Inventeur: **MAURIN, Maurice**
**944, rue Roqueturière**
**F-34100 Montpellier(FR)**
Inventeur: **PISTOULET, Bernard**
**723, avenue d'Occitanie**
**F-34100 Montpellier(FR)**
Inventeur: **TEDENAC, Jean-Claude**
**104, avenue de Ferdinand de Lesseps**
**F-34110 Frontignan(FR)**

(74) Mandataire: **L'Helgoualch, Jean**
**Cabinet Sueur et L'Helgoualch 78, rue Carnot**
**F-95240 Cormeilles-en-Parisis(FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

Rank Xerox (UK) Business Services
(-/2.18/2.0)

## Description

L'invention concerne de nouveaux matériaux semiconducteurs thermoélectriques à facteur de mérite élevé, utilisables pour la conversion thermoélectrique de l'énergie, en particulier à température ambiante, un procédé pour leur préparation, ainsi que les convertisseurs thermoélectriques obtenus à partir de tels matériaux.

Dans un convertisseur thermoélectrique (ou à effet Peltier) un courant électrique traversant la jonction de deux matériaux semiconducteurs de type p et de type n, provoque un dégagement ou une absorption de chaleur, selon le sens du courant. Cet effet est utilisé dans divers dispositifs de réfrigération, de chauffage et de régulation de température. Par exemple, dans un dispositif de réfrigération, une jonction de convertisseur thermoélectrique est placée à l'intérieur d'une enceinte thermiquement isolée et on fait passer le courant dans le sens approprié pour provoquer un abaissement de la température de cette jonction qui forme la source froide, tandis que la chaleur est dissipée au niveau de l'autre jonction qui constitue la source chaude.

Le coefficient de performance d'une pompe à chaleur, c'est-à-dire le rapport de la quantité de chaleur dégagée à la source chaude (ou absorbée à la source froide) à l'énergie électrique fournie à la pompe, est d'autant plus élevé que le facteur de mérite Z du thermoélément utilisé est grand. Ce facteur de mérite Z est lui-même lié au pouvoir thermoélectrique S (ou coefficient de Seebeck exprimé en V/°K), à la conductivité électrique $\sigma$ - ($\Omega^{-1}cm^{-1}$) et à la conductivité thermique X (W/cm. °K) du matériau, par la relation :

$$Z = S^2 \sigma/X$$

Le produit ZT du facteur de mérite par T = ($T_c$ + $T_f$)/2, température moyenne des sources chaude et froide, exprimée en °K, intervient dans le coefficient de performance et le rendement du convertisseur thermoélectrique. Pour une température T voisine de la température ambiante, le produit ZT des matériaux thermoélectriques usuels tels que le tellurure de bismuth ($Bi_2Te_3$) ou les alliages qui en sont dérivés, est généralement inférieur ou au plus égal à l'unité. Il en résulte que le coefficient de performance des pompes à chaleur réalisées à l'aide de ces matériaux est faible.

Le facteur de mérite Z d'un matériau semiconducteur donné peut être amené à sa valeur optimale Zopt par un dopage convenable (si on sait le réaliser). La valeur de Zopt d'un matériau peut être déduite des valeurs du pouvoir thermoélectrique, et des conductivités électrique et thermique, mesurées sur un échantillon du même matériau non idéalement dopé. On peut montrer par exemple, au moyen des abaques de Simon (Adv. Energy Conv. Vol. 1, 81-92, 1961 - Ibid. vol.3, 515, 1830 - J.Appl. Phys, Vol.33, 1830-41, 1962), que le coefficient ZT optimal des matériaux actuellement connus ne peut dépasser appréciablement l'unité dans les domaines de température où ils sont utilisables.

Il est donc apparu souhaitable de pouvoir mettre au point des matériaux thermoélectriques à facteur de mérite plus élevé, (ZT > 1) dont l'intérêt économique est particulièrement important pour les réalisations de pompes à chaleur statiques fonctionnant à des températures voisines de l'ambiante. Divers semiconducteurs ont été étudiés, sachant que l'on peut modifier leur coefficient de mérite par dopage, ou par écart de stoechiométrie, afin de faire varier leur pouvoir thermoélectrique et leur conductivité électrique.

La demande de brevet français 2.566.585 décrit des matériaux semiconducteurs thermoélectriques à base d'argent, de thallium et de tellure susceptibles de présenter un facteur de mérite voisin de 1 à température ambiante, utilisables dans la fabrication de pompes à chaleur à effet Peltier.

Un matériau thermoélectrique à base d'argent, de cuivre et de tellure qui peut contenir du thallium comme additif est connu de GB-A- 578187.

La présente invention a pour objet une nouvelle classe de composés semiconducteurs thermoélectriques possédant un facteur de mérite élevé, utilisables pour la conversion thermoélectrique de l'énergie, notamment dans les pompes à chaleur à effet Peltier, dans une gamme de températures s'étendant de -100°C à +100°C environ, et en particulier au voisinage de la température ambiante.

L'invention a également pour objet les convertisseurs thermoélectriques utilisant de tels matériaux, susceptibles de fonctionner non seulement à température ambiante, mais plus généralement entre -100°C et +100°C environ, ainsi qu'un procédé pour la préparation de ces matériaux.

Les nouveaux matériaux semiconducteurs thermoélectriques selon l'invention peuvent être représentés par la formule générale (I):

$$Ag_xCu_yTlTe_{1+z} \qquad (I)$$

dans laquelle x, y et z vérifient les relations suivantes :
$0,55 \leq x \leq 0,75; 0,25 \leq y \leq 0,40; 0 < z \leq 0,10$.

La formule ci-dessus délimite une zone de solution solide dans le diagramme quaternaire Ag-Cu-Tl-Te.

Les matériaux semiconducteurs thermoélectriques de formule (I) ci-dessus sont sous forme de solution solide dont les caractéristiques électriques sont plus favorables que celles des composés Ag - Tl - Te connus.

Il est important que les valeurs de x, y et z respectent les relations indiquées ci-dessus. Dans le cas contraire, les propriétés résultantes sont moins favorables. Par exemple, si x est supérieur à 0,75, on obtient une solution biphasée, faisant apparaître des joints de grains, et la valeur du facteur de mérite se trouve diminuée.

Ces nouveaux matériaux semiconducteurs thermoélectriques possèdent un facteur de mérite élevé (c'està-dire ZT généralement supérieur à 1) dans une gamme de ±100°C autour de la température ambiante. Ces matériaux sont de type p et peuvent être utilisés dans un convertisseur thermoélectrique à effet Peltier selon la revendication 7.

Les matériaux semiconducteurs de formule (I) ci-dessus peuvent être préparés par les techniques usuelles, à partir des métaux de base (argent, cuivre, thallium et tellure) mélangés par fusion, refroidissement lent autour du point de cristallisation et recuit telles que définies en revendication 4.

On sait que les caractéristiques telles que le pouvoir thermoélectrique et la conductivité électrique, qui conditionnent le facteur de mérite, dépendent de la mobilité des porteurs et sont influencées par les impuretés et les défauts du matériau semiconducteur. Il est donc avantageux de pouvoir préparer un matériau exempt d'impuretés et de défauts. A cet effet, il est nécessaire de mélanger et de fondre les poudres métalliques d'argent, de cuivre, de thallium et de tellure sous vide ou en atmosphère inerte pour éviter toute oxydation. On peut ensuite procéder à une solidification dirigée selon les méthodes de Bridgman, ou Bridgman modifié, ou effectuer un tirage sur un bain fondu à partir d'un germe.

Plus particulièrement, les métaux de base sous forme pulvérulente (argent, thallium, cuivre, tellure) sont mélangés intimememt en quantités correspondant à la stoechiométrie voulue, puis ce mélange est chauffé pour provoquer sa fusion dans un tube de quartz scellé sous vide. Il suffit de chauffer à une température supérieure à la température de fusion pendant quelques heures, par exemple 4 à 10 heures environ à 500°C, pour obtenir un milieu fondu homogène. On refroidit lentement, à raison de 5 à 10°C par heure, jusqu'à la température ambiante, environ. On obtient ainsi un lingot polycristallin, qui est broyé de préférence à l'abri de l'air, avant d'être fondu pour effectuer une solidification dirigée, comme indiqué ci-dessus.

La solidification dirigée selon la méthode de Bridgman (gradient thermique 2°C/mm, vitesse de traverse du gradient 0,15 à 0,3 mm/h, température de solidification 485°C) permet d'obtenir un lingot polycristallin du matériau thermoélectrique.

Ces méthodes de préparation concernent un matériau massif. Suivant une variante, il est possible d'envisager avec ce type de composé la formation de couches minces par les techniques habituellement utilisées à cet effet et qui procèdent par dépôt à partir de gaz comme par exemple les techniques de dépôt en phase vapeur d'un composé chimique (CVD), de dépôt d'un composé organo-métallique (OMCVD) par crackage à 500°C environ, provoquant la libération et le dépôt du métal, ou par la technique du plasma (PCVD).

Les matériaux thermoélectriques de formule (I) obtenus comme indiqué ci-dessus, conformément à l'invention se distinguent des matériaux connus en ce qu'ils possèdent un coefficient ZT voisin de 1, ou supérieur, entre -100°C et +100°C. Les valeurs typiques mesurées au voisinage de la température ambiante peuvent être supérieures ou égales à 1,7 dans certains cas. L'intérêt de ces matériaux provient de leur faible conductivité thermique, inférieure à 0,4 $W^{-1}m.k^{-1}$, et de leur forte conductivité électrique due à une mobilité élevée des porteurs de charge (de l'ordre de 100 $cm^2/Vs$, voire davantage, à température ambiante). La conductivité électrique résulte non seulement de la composition du matériau, dans le cadre de la formule (I) ci-dessus, mais aussi de la mobilité des porteurs de charge, qui dépend de la qualité cristallographique, et peut être défavorisée par la présence d'impuretés ou de joints de grains. La valeur du coefficient ZT peut donc varier sensiblement pour une même composition.

Comme indiqué ci-dessus, les matériaux semiconducteurs thermoélectriques de type p obtenus selon l'invention peuvent être utilisés pour la réalisation des pompes à chaleur. Il peuvent être associés à des semiconducteurs de type n classiques. A cet effet, on constitue des batteries de paires d'éléments de semiconducteurs de type p et de type n disposés électriquement en série et thermiquement en parallèle. L'isolement électrique entre les différentes soudures chaudes d'une part, et entre les soudures froides d'autre part, tout en assurant un bon contact thermique avec la source chaude et avec la source froide, est assuré au moyen de couches minces de céramiques isolantes, ou d'autres matériaux isolants possédant une bonne conductivité thermique. Les pompes à chaleur ainsi constituées possèdent un coefficient de performance nettement amélioré par rapport aux pompes à chaleur usuelles.

Les exemples suivant illustrent l'invention plus en détail sans en limiter la portée.

## EXEMPLE 1

$Ag_{0,62}Cu_{0,30}TlTe_{1,05}$

On mélange dans un broyeur 8,99g de thallium, 3,16g d'argent, 5,50g de tellure et 0,82g de cuivre, sous forme de poudre, en travaillant à l'abri de l'air pour éviter toute oxydation. Le mélange est introduit dans un tube de quartz pour subir le traitement thermique suivant.

On procède à la fusion du mélange pendant environ 12 heures, puis on laisse refroidir jusqu'à une température voisine de l'ambiante.

On obtient ainsi un lingot polycristallin. Le lingot est broyé à l'abri de l'air puis introduit dans un tube de Bridgman présentant une extrémité effilée. On chauffe de manière à le porter à l'état liquide à 450°C pendant 24 heures environ. On effectue ensuite une descente dans le four à la vitesse de 0,35mm/h (gradient thermique 2°C/mm). La durée totale de l'opération est de 4 semaines. On obtient ainsi un lingot présentant des fissures, dans lequel on prélève des échantillons pour effectuer des mesures des propriétés du matériau.

La conductivité électrique du semiconducteur obtenu est de 140 $\Omega^{-1}cm^{-1}$, son pouvoir thermoélectrique de 350 $\mu VK^{-1}$, et sa conductivité thermique de 0,3 $Wm^{-1}K^{-1}$. Ces valeurs correspondent à un coefficient ZT égal à 1,7.

## EXEMPLE 2

$Ag_{0,68}Cu_{0,26}TlTe_{1.05}$

On procède comme dans l'exemple 1 à partir de 8,99g de thallium, 3,47g d'argent, 5,50g de tellure et 0,71g de cuivre.

On obtient ainsi un matériau semiconducteur dont la conductivité électrique est de 50 $\Omega^{-1}cm^{-1}$, le pouvoir thermoélectrique de 370 $\mu VK^{-1}$ et la conductivité thermique de 0,3 $Wm^{-1}K^{-1}$.

## EXEMPLE 3

$Ag_{0,64}Cu_{0,28}TlTe_{1,05}$

On procède comme dans l'exemple 1 à partir de 9,0g de thallium, 3,26g d'argent, 5,50g de tellure et 0,77g de cuivre.

On obtient de la sorte un matériau semiconducteur ayant une conductivité électrique de 80 $\Omega^{-1}cm^{-1}$, un pouvoir thermoélectrique de 320 $\mu VK^{-1}$, et une conductivité thermique de 0,3 $Wm^{-1}K^{-1}$.

## Revendications

1. Matériaux semiconducteurs thermoélectriques à base d'argent, de thallium, de cuivre et de tellure, caractérisés en ce qu'ils sont représentés par la formule générale (I)

$$Ag_xCu_yTlTe_{1+z} \quad (I)$$

dans laquelle x, y et z vérifient les relations : $0,55 \leq x \leq 0,75$; $0,25 \leq y \leq 0,40$ et $0 < z \leq 0,10$.

2. Matériaux semiconducteurs thermoélectriques selon la revendication 1, caractérisés en ce que x est compris entre 0,60 et 0,70.

3. Matériau semiconducteur thermoélectrique selon la revendication 2, caractérisé en ce qu'il est représenté par la formule $Ag_{0,62}Cu_{0,30}TlTe_{1,05}$.

4. Procédé de préparation de matériaux semiconducteurs thermoélectriques selon la revendication 1, selon lequel on mélange l'argent, le cuivre, le thallium et le tellure, sous forme de poudre, on chauffe à 500°C environ, sous vide ou sous atmosphère inerte, on refroidit lentement jusqu'à température ambiante environ, pour obtenir un lingot, à partir duquel on effectue une solidification dirigée, ou un dépôt en phase vapeur.

5. Procédé selon la revendication 4, caractérisé en ce que la solidification dirigée est effectué selon la méthode de Bridgman.

6. Procédé selon la revendication 4, caractérisé en ce que le dépôt en phase vapeur est effectué pour déposer un desdites matériaux semiconducteurs thermoélectriques sur un support.

7. Convertisseur thermoélectrique à effet Peltier comportant au moins une paire d'éléments semiconducteurs de type p et de type n, caractérisé en ce que l'élément de type p est constitué par un matériau semiconducteur selon l'une quelconque des revendications 1 à 3.

## Claims

1. Silver, thallium, copper and tellurium-based thermoelectric semiconductor materials, characterized in that they are represented by the general formula (I)

$$Ag_xCu_yTlTe_{1+z} \quad (I)$$

wherein, x, y and z are :
$0{,}55 \leq x \leq 0{,}75$ ; $0{,}25 \leq y \leq 0{,}40$ and $0 < z \leq 0{,}10$.

2. Thermoelectric semiconductor materials according to claim 1, characterized in that x is comprised from 0,60 to 0,70.

3. A thermoelectric semiconductor material according to claim 2, characterized in that it is represented by the formula

$$Ag_{0{,}62}Cu_{0{,}30}TlTe_{1{,}05}$$

4. A process for preparing thermoelectric semiconductor materials according to claim 1, characterized in that silver, copper, thallium and tellurium, in the form of a powder, are mixed, the mixture is heated at about 500°C, under vacuum or inert atmosphere, the mixture is cooled slowly to about the room temperature, in order to obtain an ingot, on which then a directional solidification or a vapor deposition is performed.

5. A process according to claim 4, characterized in that the directional solidification is performed according to the Bridgman method.

6. A process according to claim 4, characterized in that the deposit in vapor phase is carried out so as to deposit one of said thermoelectric semiconductor materials on a support.

7. A Peltier effect thermoelectrical converter which includes at least one pair of p type and n type semiconductor elements, characterized in that the p type element is made from a semiconductor material according to any one of claims 1 to 3.

**Patentansprüche**

1. Thermoelektrische Halbleitermaterialien auf Basis von Silber, Thallium, Kupfer und Tellur, dadurch gekennzeichnet, daß sie durch die allgemeine Formel (I) dargestellt werden

$$Ag_xCu_yTlTe_{1+z} \qquad (I)$$

worin x, y und z den folgenden Bedingungen genügen:
$0{,}55 \leq x \leq 0{,}75$; $0{,}25 \leq y \leq 0{,}40$ und $0 < z \leq 0{,}10$.

2. Thermoelektrische Halbleitermaterialien nach Anspruch 1, dadurch gekennzeichnet, daß x zwischen 0,60 und 0,70 liegt.

3. Thermoelektrisches Halbleitermaterial nach Anspruch 2, dadurch gekennzeichnet, daß es durch die Formel dargestellt wird

$$Ag_{0{,}62}Cu_{0{,}30}TlTe_{1{,}05}.$$

4. Verfahren zur Herstellung der thermoelektrischen Halbleitermaterialien nach Anspruch 1, bei dem man das Silber, das Kupfer, das Thallium und das Tellur in Pulverform miteinander mischt, unter Vakuum oder unter einer inerten Atmosphäre auf etwa 500°C erwärmt und bis auf etwa Umgebungstemperatur langsam abkühlt zur Herstellung eines Barrens, und daß man, ausgehend von diesem, eine gerichtete Solidifikation oder eine Abscheidung in der Gasphase durchführt.

5. Verfahren nach Anspruch 4, dadurch gekennzeichnet, daß die gerichtete Solidifikation nach der Methode von Bridgman durchgeführt wird.

6. Verfahren nach Anspruch 4, dadurch gekennzeichnet, daß die Abscheidung in der Gasphase durchgeführt wird zur Abscheidung eines der genannten thermoelektrischen Halbleitermaterialien auf einem Träger.

7. Thermoelektrischer Umformer mit Peltier-Effekt, der umfaßt mindestens ein Paar von Halbleiterelementen vom p-Typ und vom n-Typ, dadurch gekennzeichnet, daß das Element vom p-Typ aus einem Halbleitermaterial nach einem der Ansprüche 1 bis 3 besteht.